# FASCICULE DE BREVET EUROPEEN

(11) **EP 2 383 746 B1**
(45) Date de publication et mention de la délivrance du brevet: **19.09.2012**
(21) Numéro de dépôt: 11160037.5
(22) Date de dépôt: 28.03.2011
(51) Int. Cl.: G11C 16/10, G11C 16/34

(54) **Procédé d'écriture et de lecture dans une mémoire d'atomicité**
Schreib- und Leseverfahren in einem Atomizitätsspeicher
Method for writing and reading in an atomicity memory

(30) Priorité: 30.04.2010 FR 1053379
(43) Date de publication de la demande: 02.11.2011
(73) Titulaire: PROTON WORLD INTERNATIONAL N.V., 1930 Zaventem (BE)
(72) Inventeur: van Assche, Gilles, 1030 Schaerbeek (BE); van Keer, Ronny, 1560 Hoeilaart (BE)
(74) Mandataire: de Beaumont, Michel

(56) Documents cités:
- EP-A1- 0 398 545
- EP-A1- 0 630 027
- EP-A1- 1 241 677
- EP-A2- 0 340 981
- EP-A2- 0 544 252
- EP-A2- 0 863 513
- US-A- 4 922 456
- US-A- 5 715 431
- US-A- 5 926 826
- US-A1- 2006 106 751

## Description

### Domaine de l'invention

La présente invention concerne le domaine des microcontrôleurs embarqués dans des éléments électroniques et la réalisation de transactions atomiques dans de tels dispositifs. Plus particulièrement, la présente invention concerne un procédé d'écriture et de lecture dans une mémoire d'atomicité.

### Exposé de l'art antérieur

Dans les microcontrôleurs embarqués, par exemple des cartes à puce avec ou sans contact, l'atomicité des transactions est primordiale. Une transaction est dite atomique si, lorsqu'elle est en cours de réalisation et qu'une interruption intervient, par exemple du fait d'une interruption de l'alimentation du dispositif, les données mémorisées dans une mémoire non volatile se retrouvent, après réactivation du dispositif, soit à l'état précédant la transaction, soit à l'état final après la transaction. Si l'état de plusieurs ensembles de points mémoire doit être changé lors d'une transaction, tous les points mémoire doivent être actualisés ou remis à leur état précédant la transaction. Pour une transaction atomique, un état intermédiaire ou indéterminé de zones stockant les données de cette transaction dans la mémoire non volatile ne doit pas être autorisé.

De nombreuses techniques sont connues pour déterminer si une transaction s'est correctement déroulée et si l'état des mémoires non volatiles auxquelles on a accédé a été correctement actualisé. Pour réaliser des transactions atomiques, il est courant d'utiliser une zone mémoire de la mémoire non volatile, que l'on appelle "mémoire (ou buffer) d'atomicité", pour stocker, avant chaque transaction, l'état des mémoires non volatiles susceptibles d'être modifiées lors de la transaction. Ceci permet, dans le cas où la transaction serait interrompue, de restaurer dans les mémoires non volatiles l'ensemble des données précédant la transaction en y réinjectant les données stockées dans le buffer d'atomicité. Il est également connu de stocker, dans un buffer d'atomicité et avant chaque transaction, les nouvelles données destinées à être stockées dans les mémoires non volatiles à la fin de la transaction. Si la transaction est interrompue, les données stockées dans le buffer d'atomicité permettent d'achever la transaction.

Dans le cas où la transaction a abouti, les données contenues dans le buffer d'atomicité sont effacées. Généralement, les buffers d'atomicité sont constitués de mémoires non volatiles effaçables électriquement et programmables, plus connues sous l'acronyme EEPROM.

Un problème lié à l'utilisation de mémoires EEPROM est que ces mémoires supportent difficilement un nombre d'écritures supérieur à 500 000 cycles et tendent à se dégrader au fur et à mesure des écritures et des effacements. De plus, la dégradation des mémoires du buffer n'est pas uniforme puisque le nombre de données à écrire dans le buffer d'atomicité varie en fonction des transactions réalisées. Ainsi, les premières zones mémoire (premières adresses mémoire) du buffer d'atomicité sont atteintes à chaque transaction tandis que les dernières zones mémoire ne sont utilisées que lors de transactions modifiant l'état d'un grand nombre de points mémoire.

Ainsi, un buffer constitué de mémoires EEPROM se dégrade au cours des écritures et lectures de façon non uniforme.

Le document US 5926826 se rapporte à une mémoire ROM reprogrammable et prévoit une étape de marquage du début des données à écrire dans des blocs mémoire, un label différent étant utilisé selon le contenu du bloc mémoire.

Le document US 4922456 décrit un système de mémorisation utilisant un double buffer pour une mémoire non volatile.

Le document EP-A-0398545 décrit un procédé de stockage en mémoire non volatile utilisant un drapeau indicateur de la donnée valide la plus récente entre des données stockés dans deux endroits différents.

Le document EP-A-1241677 décrit un système d'écriture circulaire dans une mémoire non volatile.

Le document US 2006/0106751 décrit un procédé de lecture de données dans une mémoire, les données étant stockées en utilisant un marqueur de début pour les écritures dans la mémoire.

### Résumé

Un objet d'un mode de réalisation de la présente invention est de palier tout ou partie des inconvénients des buffers d'atomicité usuels. Plus particulièrement, un objet d'un mode de réalisation de la présente invention est de prévoir un buffer d'atomicité constitué de mémoires EEPROM dont l'état est susceptible d'être modifié un grand nombre de fois.

Un autre objet d'un mode de réalisation de la présente invention est de prévoir un procédé d'écriture de données dans un buffer d'atomicité constitué de mémoires EEPROM.

Un autre objet d'un mode de réalisation de la présente invention est de prévoir un procédé de lecture de données dans un buffer d'atomicité constitué de mémoires EEPROM.

Ainsi, un mode de réalisation de la présente invention prévoit un procédé d'écriture de données dans une mémoire d'atomicité non volatile reprogrammable, dans lequel : un motif de marquage comportant plusieurs bits est ajouté au début des données ; et l'ensemble constitué du motif de marquage et des données est écrit à partir d'une adresse de la mémoire variant d'une écriture à une autre, de manière aléatoire, le motif de marquage étant identique pour chaque écriture.

Selon un mode de réalisation de la présente invention, des informations associées aux données sont ajoutées dans l'ensemble, entre le motif de marquage et les données.

Selon un mode de réalisation de la présente invention, des informations associées aux données sont imbriquées dans le motif de marquage.

Selon un mode de réalisation de la présente invention, le motif de marquage comprend au moins 64 bits.

Selon un mode de réalisation de la présente invention, le motif de marquage comprend au moins 128 bits.

Un mode de réalisation de la présente invention prévoit en outre un procédé de lecture de données dans une mémoire d'atomicité non volatile reprogrammable, les données étant écrites selon le procédé décrit ci-dessus, comprenant une étape de balayage de la mémoire de façon à reconnaître le motif de marquage et une étape de lecture des données stockées à partir des adresses mémoire suivant le motif de marquage.

Selon un mode de réalisation de la présente invention, la lecture est réalisée selon un adressage circulaire.

Un mode de réalisation de la présente invention prévoit en outre un circuit électronique comprenant une mémoire d'atomicité non volatile reprogrammable dont des zones sont écrites selon le procédé décrit ci-dessus, comprenant en outre des moyens de mémorisation d'un motif de marquage.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est un organigramme illustrant un procédé d'écriture dans un buffer d'atomicité selon un mode de réalisation de la présente invention ;
la figure 2 est un organigramme illustrant un procédé de lecture dans un buffer d'atomicité selon un mode de réalisation de la présente invention ;
la figure 3 illustre un buffer d'atomicité dans lequel sont écrites des données selon un mode de réalisation de la présente invention ; et
la figure 4 illustre une autre configuration du buffer d'atomicité de la figure 3 dans lequel sont écrites des données selon un mode de réalisation de la présente invention.

### Description détaillée

Pour éviter que la mémoire EEPROM d'une mémoire (ou buffer) d'atomicité formée dans une mémoire non volatile de stockage de données ne se dégrade prématurément du fait du grand nombre d'accès à cette mémoire, les inventeurs prévoient de réaliser une écriture dans le buffer d'atomicité à partir d'une première adresse du buffer d'atomicité variant d'une écriture à une autre. Ainsi, au fil des écritures et des lectures, toutes les adresses de la mémoire constituant le buffer d'atomicité sont écrites, lues et/ou supprimées statistiquement un même nombre de fois. Ceci permet d'augmenter la durée de vie du buffer d'atomicité.

Pour permettre la lecture des données stockées dans le buffer d'atomicité, il est prévu, avant l'écriture des données dans le buffer, de stocker un motif de marquage du début d'écriture dans le buffer. Ce motif est une suite de bits choisis par exemple aléatoirement sous commande d'un programme associé au dispositif dans lequel des transactions atomiques sont désirées. Le motif de marquage pourra également être choisi, aléatoirement ou non, pendant la personnalisation du dispositif intégrant la mémoire ou lorsque le programme est lancé sur le dispositif pour la première fois.

Un tel procédé d'écriture est ainsi compatible avec le fait que les données à stocker dans la mémoire présentent une taille variable à chaque transaction.

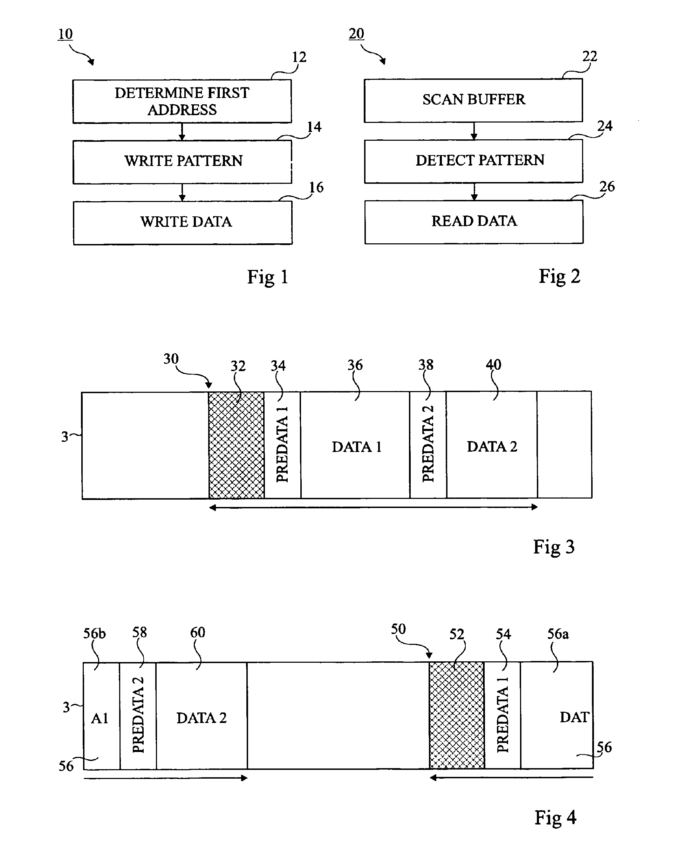

La figure 1 est un organigramme illustrant un procédé d'écriture 10 dans un buffer d'atomicité.

Une première étape 12 du procédé d'écriture (DETERMINE FIRST ADDRESS) consiste à déterminer une première adresse du buffer à partir de laquelle les données seront stockées. Cette détermination peut être réalisée par tout moyen connu, par exemple par un générateur d'adresse aléatoire. A une étape suivante 14 (WRITE PATTERN), un motif de marquage du début d'écriture est stocké dans le buffer d'atomicité, à partir de l'adresse déterminée à l'étape 12. Une dernière étape 16 du procédé d'écriture (WRITE DATA) consiste à écrire les données à stocker dans le buffer d'atomicité, à partir de l'adresse suivant la dernière adresse utilisée pour stocker le motif de marquage du début d'écriture.

La figure 2 est un organigramme illustrant un procédé de lecture 20 dans un buffer d'atomicité dans lequel des données ont été écrites selon le procédé illustré en figure 1.

Une première étape 22 du procédé de lecture (SCAN BUFFER) consiste à balayer les données contenues dans le buffer d'atomicité. Cette étape permet, en association avec une deuxième étape 24 (DETECT PATTERN), de détecter la présence du motif de marquage du début de l'écriture. Une dernière étape (READ DATA) consiste à se placer à la fin du motif de marquage pour lire les données stockées dans le buffer d'atomicité.

Pour que le motif de marquage du début d'écriture ne risque pas d'être confondu avec des données écrites à l'étape 16, ce motif de marquage doit comprendre un grand nombre de bits. Avec un motif de marquage comprenant une trentaine de bits, la probabilité que les données reproduisent le motif de marquage est déjà de l'ordre de 10⁻⁹. De préférence, le motif de marquage de début d'écriture comprend 64 bits, voire 128 bits. Ce motif sera stocké de préférence dans un endroit secret de la puce dans laquelle est prévu le buffer d'atomicité. Un motif de marquage comprenant un grand nombre de bits permet également d'éviter qu'une personne malintentionnée ne le découvre et ne l'utilise pour modifier des états de la mémoire et/ou obtienne des informations secrètes.

On notera que le buffer d'atomicité devra être prévu d'une taille suffisante pour stocker au moins le nombre maximum de données à stocker au cours d'une transaction auquel on ajoute les éléments du motif de marquage. Pour une dégradation dans le temps encore plus faible, le buffer d'atomicité pourra également être formé d'une zone de la mémoire non volatile de stockage de données comprenant un nombre de mémoires supérieur au nombre d'adresses mémoire nécessaire pour stocker le plus grand nombre de données à stocker possible lors d'une transaction. En effet, puisque toutes les adresses du buffer d'atomicité sont utilisées statistiquement un même nombre de fois, l'utilisation d'un buffer comprenant un grand nombre d'adresses mémoire limite l'accès et donc l'usure de chacune des mémoires EEPROM le constituant.

La figure 3 illustre un buffer d'atomicité 3 dans lequel sont stockées des données en suivant le procédé de la figure 1.

A partir d'une adresse de début 30 sélectionnée, par exemple aléatoirement, sont stockées des données 32 formant le motif de marquage du début d'écriture. Ensuite, dans l'ordre des adresses du buffer d'atomicité, sont mémorisées les données à stocker proprement dites. Dans l'exemple représenté, deux ensembles de données sont représentés. Le premier ensemble de données comprend des "pré-données" 34 (PREDATA1) et des données 36 (DATA1). Le second ensemble de données comprend des "pré-données" 38 (PREDATA2) et des données 40 (DATA2).

A titre d'exemple, les pré-données 34 et 38 peuvent être constituées d'informations sur l'ensemble de données associé, par exemple des données d'adresses, des codes de correction d'erreur (connus sous l'acronyme "CRC", de l'anglais Cyclic Redundancy Check), des informations sur la longueur des données. Les données 36 et 40 correspondent quant à elles aux données réellement stockées dans la mémoire avant la réalisation de la transaction.

La figure 4 illustre une autre configuration du buffer d'atomicité 3 de la figure 3 dans lequel sont écrites des données selon le procédé de la figure 1.

Dans le cas de la figure 4, l'adresse 50 de début de stockage est telle que la taille des données à stocker est supérieure au volume mémoire restant jusqu'à la fin du buffer, c'est-à-dire jusqu'à sa dernière adresse. On effectue alors un adressage circulaire pour revenir au début du buffer. Ainsi, un premier ensemble d'adresses mémoire 52 du buffer d'atomicité mémorise le motif de marquage du début de l'écriture. Ensuite, dans l'ordre des adresses du buffer d'atomicité sont mémorisées les données à stocker à proprement parler. Dans l'exemple représenté, deux ensembles de données sont stockés. Le premier ensemble de données comprend des "pré-données" 54 (PREDATA1) et des données 56 (DATA1). Le second ensemble de données comprend des "pré-données" 58 (PREDATA2) et des données 60 (DATA2). Dans l'exemple de la figure 4, les données 56 sont stockées en deux parties, une première partie 56a au niveau des dernières adresses du buffer et une seconde partie 56b à partir du début du buffer.

Ainsi, dans le cas de la figure 4, les données stockées le sont selon un adressage circulaire. De la même façon, la lecture des données à l'étape 26 sera faite selon un adressage circulaire et l'étape 22 de balayage du buffer d'atomicité également. On notera que l'on pourra également intégrer le motif de marquage de début d'écriture dans des pré-données, en une ou plusieurs parties, ou encore stocker le motif de marquage ou les pré-données en deux parties dans le buffer.

Des modes de réalisation particuliers de la présente invention ont été décrits. Diverses variantes et modifications apparaîtront à l'homme de l'art. En particulier, on a représenté en figures 3 et 4 des buffers dans lesquels deux ensembles de données sont stockées avant la réalisation d'une transaction. On notera que les buffers d'atomicité pourront, au cours de la vie de la carte dans laquelle ils sont intégrés, stocker un nombre plus ou moins important d'ensembles de données. On pourra également prévoir des buffers dans lesquels un seul ensemble de "pré-données" sera prévu pour plusieurs ensembles de données. De plus, les pré-données pourront comprendre d'autres éléments que ceux cités ici.

Enfin, l'étape de détermination de la première adresse d'écriture 12 variable et l'étape de balayage du buffer d'atomicité 22 pourront être réalisées à l'aide de tout dispositif adapté à la réalisation de ces étapes, par exemple par le microcontrôleur associé à une carte à puce.

## Revendications

1. Procédé d'écriture de données (10) dans une mémoire d'atomicité non volatile reprogrammable (3), dans lequel :
un motif de marquage (32, 52) comportant plusieurs bits est ajouté au début des données (36, 40, 56a, 56b, 60) ; et
l'ensemble constitué dudit motif de marquage et des données est écrit à partir d'une adresse de la mémoire (30, 50) variant d'une écriture à une autre de manière aléatoire, le motif de marquage étant identique pour chaque écriture.

2. Procédé selon la revendication 1, dans lequel l'adressage dudit ensemble est circulaire.

3. Procédé selon la revendication 1 ou 2, dans lequel des informations (34, 38, 54, 58) associées auxdites données (36, 40, 56, 60) sont ajoutées dans ledit ensemble, entre ledit motif de marquage (32, 52) et lesdites données.

4. Procédé selon la revendication 1 ou 2, dans lequel des informations (34, 38, 54, 58) associées auxdites données (36, 40, 56, 60) sont imbriquées dans ledit motif de marquage (32, 52).

5. Procédé selon l'une quelconque des revendications 1 à 4, dans lequel le motif de marquage (32, 52) comprend au moins 64 bits.

6. Procédé selon l'une quelconque des revendications 1 à 5, dans lequel le motif de marquage (32, 52) comprend au moins 128 bits.

7. Procédé de lecture de données (20) dans une mémoire d'atomicité non volatile reprogrammable, lesdites données étant écrites selon le procédé de l'une quelconque des revendications 1 à 6, comprenant une étape de balayage de la mémoire (22) de façon à reconnaître (24) ledit motif de marquage (32, 52) et une étape de lecture (26) des données stockées à partir des adresses mémoire suivant ledit motif de marquage.

8. Procédé selon la revendication 7, dans lequel la lecture (20) est réalisée selon un adressage circulaire.

9. Circuit électronique comprenant une mémoire d'atomicité non volatile reprogrammable (3) dont des zones sont écrites selon le procédé de l'une quelconque des revendications 1 à 6, comprenant en outre des moyens de mémorisation d'un motif de marquage.

## Claims

1. A method for writing data (10) into a reprogrammable non-volatile atomicity memory (3), wherein:
a marking pattern (32, 52) comprising several bits is added at the beginning of the data (36, 40, 56a, 56b, 60); and
the set formed of said marking pattern and of the data is written from an address in the memory (30, 50) randomly varying from one write operation to another, the marking pattern being identical for each write operation.

2. The method of claim 1, wherein the addressing of said set is circular.

3. The method of claim 1 or 2, wherein information (34, 38, 54, 58) associated with said data (36, 40, 56, 60) is added in said set, between the marking pattern (32, 52) and said data.

4. The method of claim 1 or 2, wherein information (34, 38, 54, 58) associated with said data (36, 40, 56, 60) is interleaved in said marking pattern (32, 52).

5. The method of any of claims 1 to 4, wherein the marking pattern (32, 52) comprises at least 64 bits.

6. The method of any of claims 1 to 5, wherein the marking pattern (32, 52) comprises at least 128 bits.

7. A method for reading data (20) from a reprogrammable non-volatile atomicity memory, said data being written according to the method of any of claims 1 to 6, comprising a memory scan step (22) to recognize (24) said marking pattern (32, 52) and a step of reading (26) the stored data from the memory addresses following said marking pattern.

8. The method of claim 7, wherein the reading (20) is performed according to a circular addressing.

9. An electronic circuit comprising a reprogrammable non-volatile atomicity memory (3) having areas written into according to the method of any of claims 1 to 6, further comprising means for storing a marking pattern.

## Patentansprüche

1. Verfahren zum Schreiben von Daten (10) in einen nicht-flüchtigen, reprogrammierbaren atomaren Speicher (3), in dem:
ein mehrere Bits umfassendes Markierungsmuster (32,52) am Anfang der Daten (36, 40, 56a, 56b, 60) hinzugefügt wird; und
die aus dem Markierungsmuster und den Daten gebildete Gesamtheit ab einer sich zufällig von Schreibvorgang zu Schreibvorgang ändernden Adresse des Speichers (30,50) geschrieben wird, wobei das Markierungsmuster für jeden Schreibvorgang identisch ist.

2. Verfahren nach Anspruch 1, in dem die Adressierung der Gesamtheit zirkulär ist.

3. Verfahren nach Anspruch 1 oder 2, in dem die mit den Daten (36, 40, 56, 60) verbundenen Informationen (34, 38, 54, 58) in der Gesamtheit zwischen dem Markierungsmuster (32, 52) und den Daten hinzugefügt werden.

4. Verfahren nach Anspruch 1 oder 2, in dem die mit den Daten (36,40,56, 60) verbundenen Informationen (34, 38, 54, 58) in dem Markierungsmuster (32,52) verschachtelt werden.

5. Verfahren nach einem der Ansprüche 1 bis 4, in dem das Markierungsmuster (32,52) mindestens 64 Bit umfasst.

6. Verfahren nach einem der Ansprüche 1 bis 5, in dem das Markierungsmuster (32,52) mindestens 128 Bit umfasst.

7. Verfahren zum Lesen von Daten (20) aus einem reprogrammierbaren, nicht-flüchtigen atomaren Speicher, wobei die Daten nach dem Verfahren eines der Ansprüche 1 bis 6 geschrieben sind, umfassend einen Schritt des Speicherabtastens (22), um das Markierungsmuster (32,52) zu erkennen (24), und einen Schritt des Lesens (26) der Daten, die ab den auf das Markierungsmuster folgenden Speicheradressen gespeichert sind.

8. Verfahren nach Anspruch 7, in dem das Lesen (20) gemäß einer zirkulären Adressierung erfolgt.

9. Elektronischer Schaltkreis, umfassend einen nicht-flüchtigen, reprogrammierbaren atomaren Speicher (3) dessen Bereiche gemäß dem Verfahren eines der Ansprüche 1 bis 6 beschrieben werden, der außerdem Mittel zum Speichern eines Markierungsmusters umfaßt.
